# EUROPEAN PATENT APPLICATION

(11) **EP 2 098 620 A1**
(43) Date of publication of application: **09.09.2009**
(21) Application number: 09003022.2
(22) Date of filing: 03.03.2009
(51) Int. Cl.: C30B 29/06, C30B 15/00, C30B 15/04, C30B 33/02

(54) **Method of manufacturing silicon substrate**

(30) Priority: 05.03.2008 JP 2008054843
(71) Applicant: SUMCO CORPORATION, Minato-ku, Tokyo (JP)
(72) Inventor: Kurita, Kazunari, Tokyo (JP); Omote, Shuichi, Tokyo (JP)
(74) Representative: Albrecht, Thomas

(57) **Abstract**

A method of manufacturing a silicon substrate includes: growing a silicon single crystal having a carbon concentration in the range of 1.0 × 10¹⁶ atoms/cm³ to 1.6 × 10¹⁷ atoms/cm³ and an initial oxygen concentration in the range of 1.4 × 10¹⁸ atoms/cm³ to 1.6 × 10¹⁸ atoms/cm³ using a CZ method; slicing the silicon single crystal; forming an epitaxial layer on the sliced silicon single crystal; and performing a heat treatment thereon as a post-annealing process at a temperature in the range of 600°C to 850°C.

## Description

### BACKGROUND OF THE INVENTION

### Field of the Invention

The present invention relates to a method of manufacturing a silicon substrate, and more particularly, to a technique applicable for a silicon substrate that has a high gettering capability and is used to manufacture a device, such as a solid-state imaging device.

Priority is claimed on Japanese Patent Application No. 2008-054843, filed March 5, 2008, the content of which is incorporated herein by reference.

### Description of Related Art

A thin semiconductor device made of silicon is manufactured by slicing a silicon single crystal pulled by, for example, a CZ (Czochralski) method into a silicon substrate and forming a circuit on the silicon substrate. When impurities, such as heavy metal, are mixed with the silicon substrate, device characteristics significantly deteriorate.

For example, impurities, such as heavy metal, are mixed with the silicon substrate by the following causes: first, metal contamination during a process of manufacturing a silicon substrate including single crystal pulling, slice, chamfering, and surface treatment, such as, polishing, grinding, and etching; and second, heavy metal contamination during a device manufacturing process of grinding the rear surface of a wafer to reduce the thickness of the wafer to about 50 µm after the circuit is formed.

In the related art, the following methods have been used: an IG (intrinsic gettering) method of forming an oxygen precipitate in a silicon substrate; and an EG (extrinsic gettering) method of forming a gettering site, such as backside damage, on the rear surface of a silicon substrate.

JP-A-6-338507 discloses a technique related to an IG process.

JP-A-2006-313922 discloses a technique related to carbon ion implantation, and an example of the EG method is described in paragraph [0005] in JP-A-2006-313922.

As described above, an intrinsic gettering method of performing an oxygen precipitation heat treatment to form an oxygen precipitate before epitaxial growth or an ion implantation method of implanting ions, such as carbon ions, into a silicon substrate has been used as a method of manufacturing a silicon substrate for a solid-state imaging device.

However, in recent years, as a design rule is reduced to about 100 nm in a device process, the temperature of a heat treatment tends to be reduced. In this case, it is difficult to perform sufficient precipitation in a substrate to obtain gettering capability. Therefore, JP-A-11-204771 discloses a technique that performs a heat treatment before a device manufacturing process. However, when pre-annealing is performed before an epitaxial process, scratches are likely to occur in the rear surface of a substrate.

When a high-temperature heat treatment is performed on a carbon-implanted substrate as in JP-A-2006-313922, crystal defects (for example, crystal lattice strain) formed by carbon implantation are reduced. As a result, the function of gettering sinks is likely to deteriorate.

### SUMMARY OF THE INVENTION

The present invention has been made in order to solve the above-mentioned problems, and an object of the present invention is to provide a method of manufacturing a silicon substrate that has sufficient gettering capability even when a process temperature is reduced in a device process, can prevent the occurrence of scratches in a silicon substrate, can reduce the generation of white spots, and can improve device yield.

According to an aspect of the present invention, there is provided a method of manufacturing a silicon substrate. The method includes: growing a silicon single crystal having a carbon concentration in the range of 1.0 × 10¹⁶ atoms/cm³ to 1.6 × 10¹⁷ atoms/cm³ and an initial oxygen concentration in the range of 1.4 × 10¹⁸ atoms/cm³ to 1.6 × 10¹⁸ atoms/cm³ using a CZ method; slicing the silicon single crystal; forming an epitaxial layer on the sliced silicon single crystal; and performing a heat treatment thereon as a post-annealing process at a temperature in the range of 600 to 850°C.

According to another aspect of the present invention, a silicon substrate for a solid-state imaging device is manufactured by the manufacturing method according to the above-mentioned aspect.

A silicon substrate applicable for manufacturing a solid-state imaging device according to the present invention has precipitate nuclei (gettering sinks of heavy metal) by the addition of carbon, and includes a silicon epitaxial layer formed thereon.

When the silicon substrate is used to manufacture a solid-state imaging device, it is possible to prevent the occurrence of defects in a transistor and a buried photodiode of the solid-state imaging device due to heavy metal contamination, and it is possible to prevent the generation of white spots in the solid-state imaging device. As a result, it is possible to improve the yield of a solid-state imaging device.

Therefore, according to the present invention, since the silicon substrate has high gettering capability, it is possible to provide a silicon substrate capable of reducing the influence of metal contamination. Therefore, it is possible to reduce manufacturing costs and prevent the generation of particles in a device process.

### BRIEF DESCRIPTION OF THE DRAWINGS

FIGS. 1 A to 1C are front cross-sectional views illustrating a silicon substrate in each process of a method of manufacturing a silicon substrate according to an embodiment of the present invention;
FIGS. 2A to 2F are diagrams illustrating a manufacturing process of a solid-state imaging device;
FIG. 3 is a flowchart illustrating a manufacturing process of the silicon substrate according to the embodiment of the present invention;
FIG. 4 is a longitudinal cross-sectional view illustrating a CZ pulling furnace;
FIG. 5 is a diagram schematically illustrating a variation in pulling speed range due to the addition of hydrogen;
FIG. 6 is a diagram illustrating a heat treatment according to the embodiment of the present invention;
FIG. 7 is a diagram illustrating the slice positions of a silicon single crystal when carbon concentration Cs is changed;
FIG. 8 is a graph illustrating the relationship between the number of white spots WS generated and the post-annealing conditions; and
FIG. 9 is a graph illustrating the relationship between the number of white spots WS generated and the carbon concentration Cs.

### DETAILED DESCRIPTION OF THE INVENTION

Hereinafter, a silicon substrate and a method of manufacturing the same according to an embodiment of the present invention will be described with reference to the accompanying drawings.

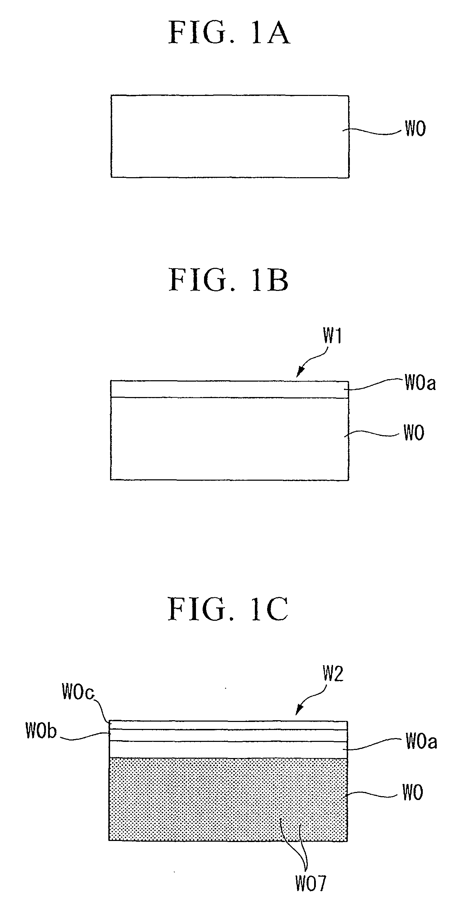

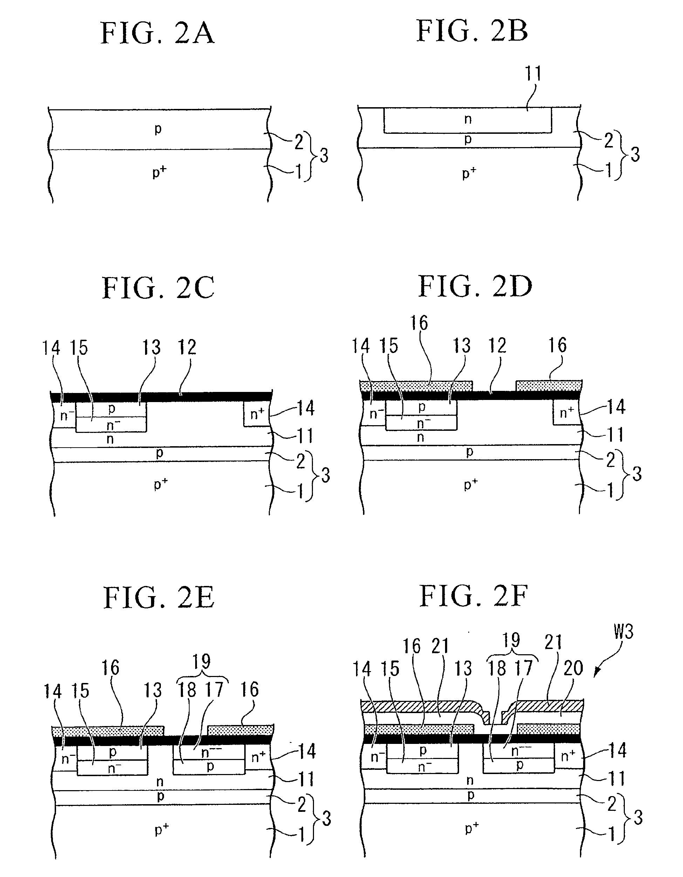

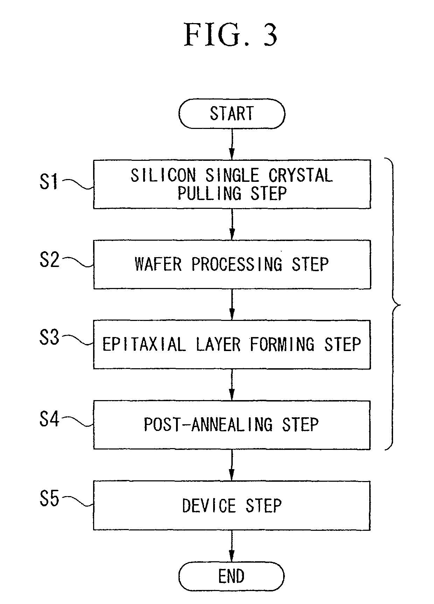

FIGS. 1A to 1C and FIGS. 2A to 2F are front cross-sectional views illustrating processes of a method of manufacturing a silicon substrate according to this embodiment, and FIG. 3 is a flowchart illustrating the method of manufacturing a silicon substrate according to this embodiment. In the drawings, reference numeral W0 denotes a silicon substrate.

In this embodiment, a silicon substrate used to manufacture a solid-state imaging device will be described.

As shown in FIG. 3, the manufacturing method according to this embodiment includes a wafer manufacturing process including a silicon single crystal pulling step S1, a wafer processing step S2, an epitaxial layer forming step S3, and a post-annealing step S4, and a device step S5.

In the example shown in FIGS. 1A to 1C, first, as shown in the silicon single crystal pulling step S1 of FIG. 3, polysilicon, which is a raw material of a silicon crystal, is placed in a silica crucible, and a predetermined amount of graphite powder is applied on the surface of the polysilicon. At the same time, when a set substrate is p- type, boron (B) is injected as a dopant. For example, the CZ crystal having carbon added thereto is pulled up in a hydrogen atmosphere by a Czochralski method (CZ method), which will be described below. The CZ crystal means a crystal that is manufactured by the Czochralski method and includes a magnetic field-applied CZ crystal.

In this embodiment, in order to obtain the silicon single crystal, carbon is added to a raw material to make a carbon-added raw material, and a silicon single crystal is produced from the carbon-added raw material. Then, the oxygen concentration Oi of the silicon single crystal is controlled to pull the silicon single crystal. Next, the pulling of the carbon-added CZ silicon single crystal will be described. A wafer having a diameter of 300 mm will be described, but the present invention is not limited thereto.

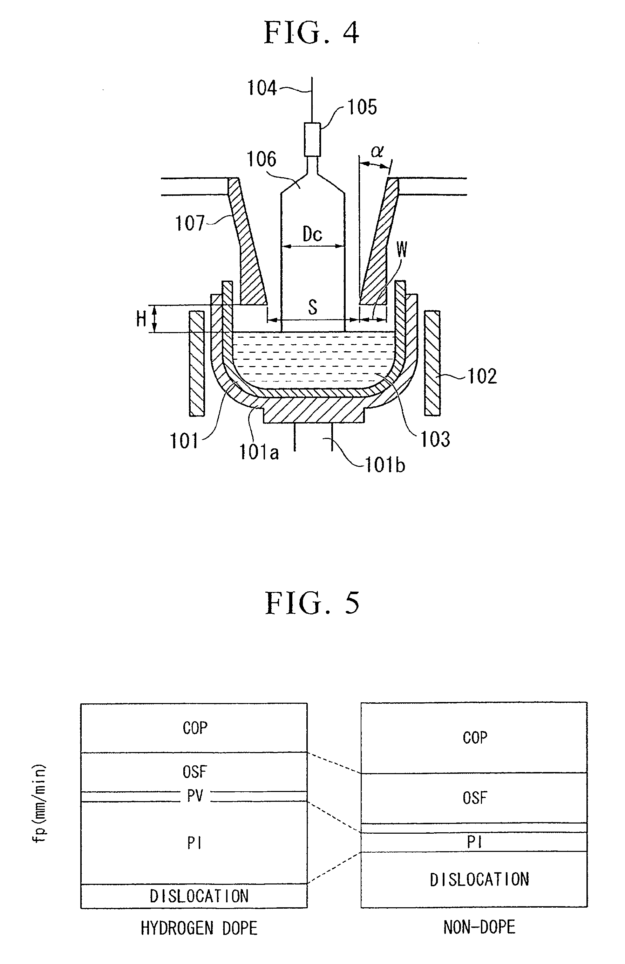

FIG. 4 is a longitudinal cross-sectional view illustrating a CZ furnace suitable to describe a method of producing a silicon single crystal according to this embodiment. The CZ furnace includes a crucible (silica crucible) 101 that is arranged at the center in a chamber and a heater 102 that is arranged outside the crucible 101. The crucible 101 has a double structure in which an outer graphite crucible 101a holds an inner silica crucible 101 having a raw material melt 103 contained therein, and is rotated and moved up and down by a supporting shaft 101b called a pedestal. A cylindrical thermal shield 107 is provided above the crucible 101. The outer shell of the thermal shield 107 is made of graphite, and the thermal shield has graphite felt filled therein. The thermal shield 107 has a tapered inner surface having a diameter that is gradually reduced from the upper end to the lower end. The upper outer surface of the thermal shield 107 has a tapered shape corresponding to the tapered inner surface, and the lower outer surface thereof is substantially straight (vertical) such that the thickness of the thermal shield 107 is gradually increased downward.

The CZ furnace can grow a 300-mm single crystal having a target diameter of, for example, 310 mm and a body length of, for example, 1,200 mm.

The thermal shield 107 has the following dimensions. The outside diameter of a portion that is placed in the crucible is, for example, 570 mm, the minimum inside diameter S of the lowermost portion is, for example, 370 mm, and the width (thickness) W of the thermal shield in the radial direction is, for example, 100 mm. In addition, the outside diameter of the crucible 101 is, for example, 650 mm, and a height H from a melt surface of the lower end of the thermal shield 107 is, for example, 60 mm.

Next, a method of setting operation conditions for growing the carbon-added CZ silicon single crystal will be described.

First, high-purity polycrystal silicon is put into the crucible, and a boron (B) dopant having a concentration that is lower than that of a p type substrate is added such that the resistivity of the crystal becomes p- type.

In this embodiment of the present invention, p+ boron (B) concentration corresponds to a resistivity in the range of 8 mΩcm to 10 mΩcm, and p boron concentration corresponds to a resistivity in the range of 0.1 Ωcm to 100 Ωcm. In addition, p boron concentration corresponds to a resistivity in the range of 0.1 Ωcm to 0.01 Ωcm. In addition, n+ phosphorus (P) concentration corresponds to a resistivity in the range of 8 mΩcm to 10 mΩcm, and n phosphorus concentration corresponds to a resistivity in the range of 0.1 Ωcm to 100 Ωcm, and n- phosphorus concentration corresponds to a resistivity in the range of 0.1 Ωcm to 0.01 Ωcm.

Further, a p/p- type means a wafer having a p type epitaxial layer formed on a p-type substrate, and a p/n- type means a wafer having a p type epitaxial layer formed on an n-type substrate.

In this embodiment, a dopant is added to a silicon melt such that the carbon concentration is in the above-mentioned range.

Further, for example, the crystal rotation speed, the crucible rotation speed, heating conditions, magnetic field conditions, and the pulling speed are controlled to obtain the above-mentioned oxygen concentration.

The internal pressure of the furnace is set in the range of 1.33 kPa to 26.7 kPa (10 ton to 200 torr), which is a reduced pressure range, in an inert gas atmosphere. In addition, 3 to 20 percent by volume of hydrogen gas is mixed with an inert gas (for example, Ar gas) and the mixed gas is introduced into the furnace. The pressure is 1.33 kPa (10 torr) or more, preferably in the range of 4 kPa to 26.7 kPa (30 torr to 200 torr), and more preferably in the range of 4 kPa to 9.3 kPa (30 torr to 70 torr). When the partial pressure of hydrogen is lowered, the concentration of hydrogen in the melt and crystal is lowered. Therefore, the lower limit of the pressure is defined in order to prevent the lowering of the hydrogen concentration. When the internal pressure of the furnace is increased, the gas flow rate on the melt of an inert gas, such as Ar, is lowered. Then, a reactant gas, such as carbon degassed from a carbon heater or a carbon member or SiO evaporated from a melt, is not easily exhausted, and the concentration of carbon in crystal is higher than a desired value. In addition, SiO is agglutinated on an inner portion of the furnace that is above the melt and has a temperature of about 1,100°C or less, and dust is generated and falls into the melt. As a result, crystal dislocation occurs. Therefore, the upper limit of the pressure is defined in order to prevent crystal dislocation.

Then, silicon is heated and melted by the heater 102 to obtain a melt 103. Then, a seed crystal held by a seed chuck 105 is immersed in the melt 103, and the crucible 101 and a pulling shaft 104 are rotated to pull a crystal. Any one of {100}, {111}, and {110}-oriented crystals is used, and seed-narrowing is performed to remove crystal dislocation. Then, a shoulder portion is formed, and the shoulder portion is changed to obtain a target body diameter of, for example, 310 mm.

Thereafter, a body portion having a length of, for example, 1,200 mm is grown at a constant pulling speed, and the body portion is compressed under normal conditions. Then, tail-narrowing is performed, and the crystal growth operation is completed. In this case, the pulling speed is appropriately determined depending on, for example, resistivity, the diameter of a silicon single crystal, and/or the hot zone structure (thermal environment) of the single crystal pulling apparatus used. For example, qualitatively, a pulling speed including the range in which an OSF ring is generated in a single crystal plane can be used. The lower limit of the pulling speed may be equal to or higher than the pulling speed that generates the OSF ring region in the single crystal plane but does not generate a dislocation cluster.

The concentration of hydrogen in the inert atmosphere may be in the range of 3% to 20% with respect to the internal pressure of the furnace in the range of 4.0 kPa to 9.33 kPa (30 torr to 70 torr). The internal pressure of the furnace is equal to or higher than 1.33 kPa (10 torr), preferably in the range of 4.0 kPa to 26.7 kPa (30 torr to 200 torr), and more preferably in the range of 4.0 kPa to 9.3 kPa (30 torr to 70 torr). When the partial pressure of hydrogen is lowered, the concentration of hydrogen in a melt and crystal is lowered. Therefore, the lower limit of the pressure is defined in order to prevent the lowering of the hydrogen concentration. When the internal pressure of the furnace is increased, a gas flow rate on the melt of an inert gas, such as Ar, is lowered. Then, a reactant gas, such as carbon degassed from a carbon heater or a carbon member or SiO evaporated from a melt, is not easily exhausted, and the concentration of carbon in crystal is higher than a desired value. In addition, SiO is agglutinated on an inner portion of the furnace that is above the melt and has a temperature of about 1,100°C or less, and dust is generated and falls into the melt. As a result, crystal dislocation occurs. Therefore, the upper limit of the pressure is defined in order to prevent crystal dislocation. It is preferable that the partial pressure of hydrogen be equal to or higher than 40 Pa and equal to or lower than 400 Pa.

When silicon growth is performed in an inert atmosphere including hydrogen, the concentration of hydrogen in the silicon single crystal can be controlled by the partial pressure of hydrogen in the atmosphere. When hydrogen is introduced into a crystal, hydrogen in the atmosphere is dissolved in a silicon melt and becomes a normal (equilibrium) state. In addition, when hydrogen is agglutinated to a crystal, hydrogen concentrations in a liquid phase and a solid phase are distributed by concentration segmentation.

The concentration of hydrogen in a melt is determined depending on the partial pressure of hydrogen in a gas phase by Henry's law. The concentration of hydrogen in the crystal immediately after congelation can be controlled to a desired constant value in the axial direction of the crystal by controlling the partial pressure of hydrogen in the atmosphere.

According to the silicon single crystal growing method, since a silicon single crystal is pulled in an inert atmosphere including hydrogen, COP and a dislocation cluster are not included in the entire region in the diametric direction of a crystal. In addition, since the silicon single crystal is pulled while widening the range of a PI region pulling speed capable of pulling a single crystal in an interstitial silicon-dominated region (PI region), a straight portion of the single crystal can become the interstitial silicon-dominated region (PI region) without a dislocation cluster. Furthermore, according to the silicon single crystal growing method, the width of the OSF ring is reduced. In the related art, when a grown-in defect-free single crystal is pulled, the PI region pulling speed needs to be set in a very narrow range. However, in this embodiment, it is possible to very easily grow a grown-in defect-free single crystal at a pulling speed that is higher than that in the related art. In addition, when a silicon single crystal is pulled under the conditions that an OSF ring region is generated in the crystal plane, it is possible to decrease the width of the OSF ring and reduce the influence of the OSF ring.

In the embodiment, the PI region pulling speed range in a hydrogen atmosphere is compared with that in an inert atmosphere without hydrogen under the conditions that the value of a temperature gradient G in the axial direction of a crystal immediately after congelation does not vary.

Specifically, in the hydrogen atmosphere, the PI region pulling speed range capable of pulling a grown-in defect-free single crystal that is composed of an interstitial-silicon-type grown-in defect-free region (PI region) is four times or more that in the atmosphere without hydrogen. In addition, as shown in FIG. 5, in the hydrogen atmosphere, the pulling speed has a margin that is 4.5 times that in the atmosphere without hydrogen. Therefore, the above-mentioned pulling speed range makes it possible to pull a desired single crystal.

In this case, it is possible to reduce the region in which the OSF ring is generated. In addition, the size of a PV region (vacancy-type grown-in defect-free region) does not vary by the addition of hydrogen.

In this embodiment, as described above, the addition of hydrogen makes it easy to pull a grown-in defect-free single crystal, and the addition of carbon makes it possible to reduce the influence of the OSF ring. Therefore, when an epitaxial layer is grown on a wafer, defects caused by the OSF ring can be reduced and a single crystal having a desired quality can be pulled by the synergistic effect of the addition of hydrogen and the addition of carbon. As a result, operating efficiency is improved, and it is possible to significantly reduce the manufacturing cost of a silicon single crystal or a silicon substrate manufactured from the silicon single crystal.

After the silicon single crystal pulling step S1 shown in FIG. 3, as shown in the wafer processing step S2 of FIG. 3, the carbon-added CZ silicon single crystal is processed into a silicon substrate W0 including carbon, as shown in FIG. 1A.

In the wafer processing step S2, a general method is performed to process the silicon substrate (wafer) W0. That is, a cutting apparatus, such as an ID saw or a wire saw, is used to slice the silicon single crystal to obtain a silicon wafer, annealing is performed on the silicon wafer, and surface treatments, such as polishing and cleaning, are performed on the silicon wafer. In addition to these processes, there are various processes, such as wrapping, cleaning, and grinding. The order of the processes may be changed, and the processes may be appropriately omitted for the purpose of use.

A silicon substrate 1 obtained by the above-mentioned processes has a p- type dopant concentration. The carbon concentration of the silicon substrate is in the range of 1.0 × 10¹⁶ atoms/cm³ to 1.6 × 10¹⁷ atoms/cm³, and the oxygen concentration thereof is in the range of 1.4 × 10¹⁸ atoms/cm³ to 1.6 × 10¹⁸ atoms/cm³.

Since carbon in a solid solution state is included in silicon, carbon is introduced into a silicon lattice so as to be substituted for silicon. That is, the radius of a carbon atom is smaller than that of a silicon atom. Therefore, when carbon is disposed at a substitution position, the stress field of a crystal becomes a compression stress field, and interstitial oxygen and impurities are likely to be gettered in the compression stress field. For example, in the device step, a high-density oxygen precipitate involving dislocation is likely to be generated from carbon at the substitution position, and it is possible to give a high gettering effect to the silicon substrate W0. In this way, it is possible to obtain sufficient gettering capability in the device step S5, which will be described below.

It is necessary to regulate the concentration of carbon added in the above-mentioned range. The reason is that, if the carbon concentration is lower than the above-mentioned range, the formation of an oxygen/carbon-based precipitate is not accelerated and the above-mentioned high-density oxygen/carbon-based precipitate is not formed.

On the other hand, if the carbon concentration is higher than the above-mentioned range, the formation of an oxygen/carbon-based precipitate is accelerated, and a high-density oxygen/carbon-based precipitate is obtained. However, the size of the precipitate is regulated. As a result, strain around the precipitate tends to be reduced. Therefore, the effect of strain is reduced, and the effect of gettering impurities is reduced.

Furthermore, it is necessary to regulate the oxygen concentration Oi in the silicon substrate W0 in the above-mentioned range. The reason is that, if the oxygen concentration is lower than the above-mentioned range, the formation of a carbon/oxygen-based precipitate is not accelerated and the above-mentioned high-density precipitate is not obtained.

On the other hand, if the oxygen concentration is higher than the above-mentioned range, the size of the oxygen precipitate is decreased, and the effect of strain in an interface between a maternal silicon atom and a precipitate is reduced. As a result, a gettering effect due to strain is reduced.

Then, as shown in the wafer processing step S2 of FIG. 3, mirror processing is performed on the surface of the silicon substrate W0, which is a carbon-added CZ crystal, and RCA cleaning, which is a combination of, for example, SC1 and SC2, is performed on the silicon substrate. Then, as shown in the epitaxial layer forming step S3 of FIG. 3, the silicon substrate is put into an epitaxial growth furnace in order to grow an epitaxial layer, and various CVD (chemical vapor deposition) methods are used to grow an epitaxial layer W0a having, for example, a p type dopant concentration, as show in FIG. 1B.

As shown in FIG. 1C, in a silicon substrate W1 of a p/p- type having the epitaxial layer W0a formed thereon, if necessary, an oxide film W1b and a nitride film W1c are formed on the epitaxial layer W0a to form a silicon wafer W2. Then, the silicon wafer W2 is supplied to the next step, such as a device manufacturing step.

In this case, the silicon substrate W0 of the silicon substrate W1 or the silicon substrate W2 supplied to the device manufacturing step is a CZ crystal including boron and solute carbon. An oxygen precipitate nucleus or an oxygen precipitate formed during crystal growth is shrunken by a heat treatment when epitaxial growth is performed. Therefore, the oxygen precipitate formed in the silicon substrate W0 in the stage of the silicon substrate W1 is not observed by an optical microscope.

Then, as shown in the post-annealing step S4 of FIG. 3, in order to ensure a gettering sink for gettering heavy metal, after the epitaxial layer W0a is grown, it is necessary to perform a low-temperature heat treatment under the conditions of a temperature of about 600°C to 850°C capable of accelerating the formation of a precipitate, a process time of 0.25 hours to 4 hours, and a mixed atmosphere of oxygen and an inert gas, such as argon or nitrogen, to deposit an oxygen precipitate W07 from carbon at a substitution position.

In the present invention, the carbon/oxygen-based precipitate means a complex (cluster) including carbon.

In the post-annealing step S4, if a heat treatment for obtaining an IG effect is performed at a temperature that is lower than the above-mentioned temperature range, a complex of carbon and oxygen is not sufficiently formed. When metal contamination occurs in the substrate, it is difficult to obtain sufficient gettering capability, which is not preferable. On the other hand, if the heat treatment is performed at a temperature that is higher than the above-mentioned temperature range, an excessively large amount of oxygen precipitate is agglutinated. As a result, the density of the gettering sinks is insufficient, which is not preferable.

The temperature and the process time of the heat treatment may be changed as long as the same precipitation effect as that under the conditions of a temperature of 600°C and a process time of 30 minutes can be obtained. The temperature and the process time of the heat treatment may be changed as long as the same precipitation effect as that under the conditions of a temperature of 800°C and a process time of 4 hours can be obtained.

If the silicon substrate W1 including solute carbon after the post-annealing step S4 is used as a base material, the oxygen precipitate W07 is spontaneously precipitated from the entire silicon substrate W0 in an initial stage of the device manufacturing step. Therefore, in the device step S5, it is possible to form gettering sinks having high gettering capability for metal contamination over the entire thickness of the silicon substrate W0 from immediately below the epitaxial layer. As a result, gettering is performed near the epitaxial layer.

In order to achieve the gettering, it is preferable that the oxygen precipitate (BMD) W07, which is a carbon/oxygen-based complex, in the silicon substrate W0 after the post-annealing step S4 have a density in the range of 1.0 × 10⁶ BMDs/cm³ to 1.0 × 10¹¹ BMDs/cm³ and a size in the range of 10 nm to 100 nm.

In this case, the BMD size means the length of the diagonal line of a precipitate in the cross-sectional TEM image of the silicon substrate in the thickness direction, and indicates the average value of the precipitates in an observation field.

If the size of the oxygen precipitate W07 after the post-annealing step S4 is greater than the lower limit of the above-mentioned range, it is possible to increase the probability of gettering interstitial impurities (for example, heavy metal) using the effect of strain occurring in an interface between a maternal silicon atom and the oxygen precipitate. On the other hand, if the size of the oxygen precipitate W07 is greater than the above-mentioned range, the strength of the substrate is lowered or dislocation occurs in the epitaxial layer, which is not preferable.

It is preferable that the density of the oxygen precipitate W07 in the silicon substrate be in the above-mentioned range since the gettering of heavy metal in the silicon crystal depends on strain occurring in an interface between the maternal silicon atom and the oxygen precipitate and an interface level density (volume density).

As shown in the device step S5 of FIG. 3, a structure, serving as a device, is formed on the surface of the silicon wafer W2 to manufacture a silicon substrate W3, as shown in FIG. 2F.

As the device step S5 applied to a solid-state imaging device, a general solid-state imaging device manufacturing process can be used. For example, a CCD device manufacturing process is shown in FIGS. 2A to 2F, but the present invention is not limited thereto.

That is, in the device step S5, first, as shown in FIG. 2A, a silicon substrate 3 having a p type epitaxial layer 2 formed on the p- silicon substrate 1 shown in FIG. 1B is prepared. Then, as shown in FIG. 2B, a first n type well region 11 is formed at a predetermined position of the epitaxial layer 2. Then, as shown in FIG. 2C, a gate insulating film 12 is formed thereon, and p type and n type impurities are selectively implanted into the first n type well region 11 by ion implantation to form a p type transmission channel region 13, an n type channel stop region 14, and a second n type well region 15 forming a vertical transmission register.

Then, as shown in FIG. 2D, transmission electrodes 16 are formed at predetermined positions on the surface of the gate insulating film 12. Then, as shown in FIG. 2E, p type and n type impurities are selectively implanted between the p type transmission channel region 13 and the second n type well region 15 to form a photodiode 19 having a laminated structure of an n type positive charge storage region 17 and a p type impurity diffusion region 18.

Then, as shown in FIG. 2F, an interlayer insulating film 20 is formed thereon, and a light-shielding film 21 is formed on the surface of the interlayer insulating film 20 except for a portion immediately above the photodiode 19 to manufacture the substrate W3 serving as a solid-state imaging device 10.

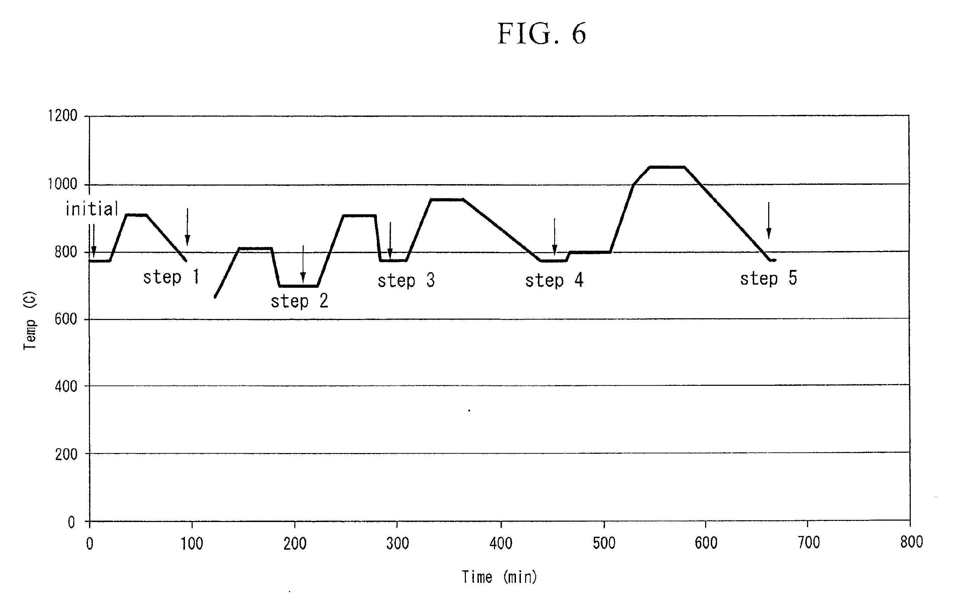

The heat treatment conditions of the device step S5 of manufacturing the solid-state imaging device 10 correspond to the conditions shown in FIG. 6.

Specifically, Initial, Step 1, Step 2, Step 3, Step 4, and Step 5 shown in FIG. 6 correspond to the end times of steps of a process of forming a photodiode and a transmission transistor for the silicon substrate W1 having the epitaxial layer W0a formed thereon.

In the case of a solid-state imaging device, it is preferable that the thickness of the epitaxial layer W0a be in the range of 2 to 10 µm, in order to improve spectral sensitivity characteristics of the device.

A buried photodiode is formed in the epitaxial layer W0a of the silicon wafer W2 in the device step to manufacture a solid-state imaging device.

It is preferable that the thickness of the oxide film W0b be in the range of 50 to 100 nm and the thickness of the nitride film W0c, specifically, the thickness of a polysilicon gate film W1b of the solid-state imaging device be in the range of 1.0 to 2.0 µm, because of restrictions in the design of the driving voltage of a transmission transistor.

In the device step S5, for example, a heat treatment is generally performed at a temperature in the range of about 600°C to 1,000°C during, for example, a gate oxide film forming process, an element separation process, and a polysilicon gate electrode forming process. The heat treatment makes it possible to deposit the oxygen precipitate W07, and the oxygen precipitate can act as gettering sinks in the subsequent step.

The heat treatment conditions in the device step S5 can correspond to the conditions shown in FIG. 6.

Next, a method of setting the heat treatment conditions in the post-annealing step S4 will be described.

During the manufacture of the solid-state imaging device, it is important to manage the number of white spots (WS) generated as device specifications. The white spots are likely to be generated due to heavy metal contamination during a manufacturing process, and it is important to getter the contaminated heavy metal in the gettering sink in the silicon substrate. The generation conditions of the gettering sink can be controlled by carbon concentration, oxygen concentration, and dopant concentration set when a silicon single crystal is pulled to manufacture a slice substrate, and the heat treatment conditions in the post-annealing step S4.

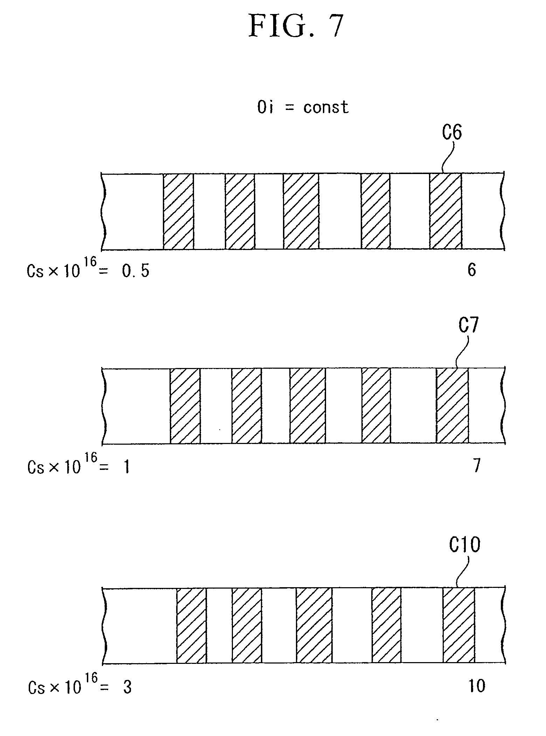

Therefore, first, as shown in FIG. 7, a plurality of single crystals having different conditions are pulled in the silicon single crystal pulling step S1 in the initial allowable range of the white spots. In the example shown in FIG. 7, the oxygen concentration Oi is constant, and the carbon concentration Cs is changed in the crystal axial direction (growth direction) such that the single crystals have carbon concentrations Cs in the range of 0.5 × 10¹⁶ atoms/cm³ to 6.0 × 10¹⁶ atoms/cm³, in the range of 1.0 × 10¹⁶ atoms/em³ to 7.0 × 10¹⁶ atoms/cm³, and in the range of 3.0 × 10¹⁶ atoms/cm³ to 10 × 10¹⁶ atoms/cm³. In addition, although not shown in the drawings, the carbon concentrations are changed, similar to FIG. 7, and single crystals having an oxygen concentration Oi (constant) that is different from that shown in FIG. 7 are pulled by the same method.

In the wafer processing step S2, the single crystals are sliced into silicon substrates having different carbon concentrations and oxygen concentrations, and an epitaxial film is formed on the silicon substrate in the epitaxial layer forming step S3, as described above. Then, first, the post-annealing step S4 is performed on the silicon substrate under predetermined initial post-annealing conditions, and a solid-state imaging device is manufactured in the device step S5. Then, in the device, the number (density) of white spots WS generated per unit area or unit element (pixel) is measured.

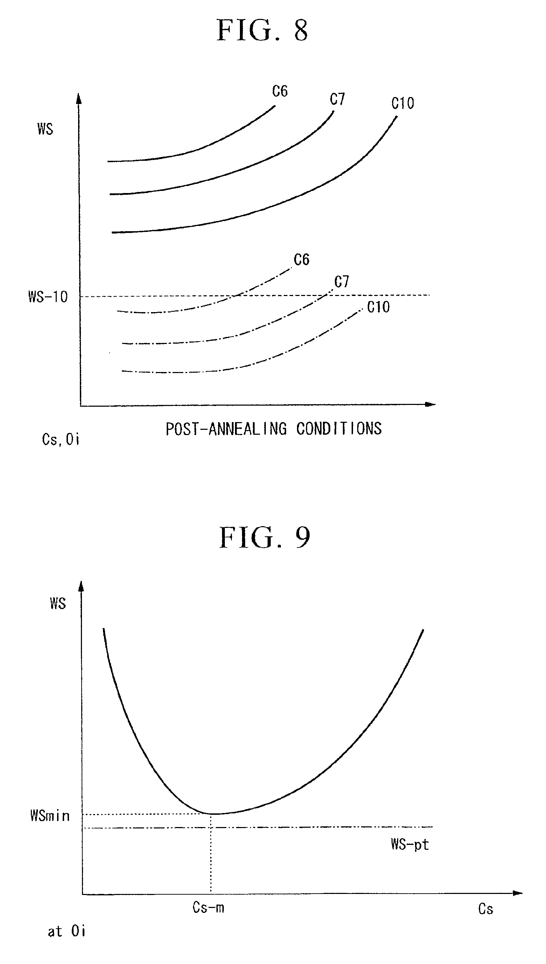

The number of white spots WS generated is reduced by the conditions of the post-annealing step. As represented by one-dot chain lines in FIG. 8, when post-annealing is performed, the number of white spots WS generated is smaller than that when post-annealing is not performed, which is represented by solid lines in FIG. 8. In Fig. 8, the post-annealing conditions represented by the horizontal axis include temperature and time, and are set on the basis of the precipitation conditions. In addition, in FIG. 8, C6, C7, and C10 correspond to wafers obtained by slicing the single crystals at the positions having the carbon concentrations shown in FIG. 7.

Then, the post-annealing conditions where white spots are generated beyond the initial allowable range of white spots (in this case, an upper limit of, for example, 10 white spots/unit pixel), which is represented by WS-10 in FIG. 8, are removed from the above-mentioned results, and new post-annealing conditions are set. Then, the set conditions are fed back to the post-annealing step S4.

In this case, when the oxygen concentration Oi and the carbon concentration Cs are changed, the number of white spots WS generated is changed as shown in FIG. 8. Therefore, the conditions of the post-annealing step S4 are set considering the concentrations. FIG. 9 shows an example in which the oxygen concentration Oi is fixed and the carbon concentration Cs is changed.

In this example, it is possible to set an optimal carbon concentration Cs-m capable of reducing the number of white spots generated to a minimum value WSmin.

In the silicon substrate according to this embodiment, during an ingot pulling process, carbon is doped to adjust the oxygen concentration in a predetermined range, and a heat treatment is performed under the above-mentioned conditions in the post-annealing step S4 to accelerate the enhancement of a precipitate, serving as a gettering sink, such that a bulk below a DZ layer has IG capability. Therefore, it is possible to maintain sufficient gettering capability in the device step. As a result, it is possible to obtain a silicon substrate capable of preventing the generation of white spots.

The substrate according to this embodiment of the present invention can be used as a wafer for a multi chip package (MCP), such as NAND-FLASH or NOR-FLASH. In this case, since the device structure is CMOS, it is possible to maintain high gettering capability by IG in the above-mentioned dopant, carbon, and oxygen concentration ranges.

For the influence of a precipitate in the post-annealing step S4, in this embodiment, when the substrate has a low p type dopant concentration or when the substrate is doped with an n type dopant, the density of the precipitates deposited from the substrate by a heat treatment in the subsequent low-temperature device process is increased, as compared to when a substrate has a high p type dopant concentration. However, the size of the precipitate is small, and a sufficient gettering sink is not formed. Therefore, it is difficult to obtain sufficiently high gettering capability. In order to reduce the influence of the precipitate and give high gettering capability, it is important to accelerate the formation of a complex defect of carbon and oxygen by the post-annealing step S4.

The range of the gettering capability is set such that, assuming that heavy metal contamination occurs in the surface of the substrate, no white spots are generated even when heavy metal is diffused by the subsequent heat treatment.

These conditions can be set such that, for example, when the contamination level of Ni, which is a contamination source, is about 1 × 10¹² atoms/cm² and when the contamination level of Cu, which is a contamination source, is about 1 × 10¹³ atoms/cm², gettering capability that can reduce a surface contamination level to a detection limit (Ni: 1 × 10¹⁰ atoms/cm², and Cu: 1 × 10⁹ atoms/cm²) is obtained after a heat treatment is performed under the heat treatment conditions in the device step corresponding to the conditions shown in FIG. 6. In this case, it is possible to set the size and density of BMDs existing in the silicon substrate W0 as intrinsic gettering sinks required to obtain the gettering capability in the above-mentioned ranges.

In the silicon single crystal heavily doped with boron (B), an oxygen precipitate is more likely to be agglutinated by a heat treatment, as compared to the silicon single crystal lightly doped with boron or doped with other dopants, such as phosphorus (P). This is because high-concentration boron and impurities, such as oxygen, are likely to be clustered to form an oxygen precipitate nucleus. In addition, the agglutination of the oxygen precipitate by a heat treatment caused by boron becomes remarkable in a silicon crystal having a high oxygen concentration. Therefore, the present invention can be applied to a silicon substrate having a low boron concentration or a substrate doped with phosphorus other than boron, not a silicon substrate heavily doped with boron.

In addition, since the post-annealing step S4 is performed after the epitaxial layer forming step S3, it is possible to prevent the occurrence of scratches in the rear surface of a substrate during annealing.

In addition, since the post-annealing step S4 is performed after the epitaxial layer forming step S3, it is possible to prevent gettering capability from being lowered when metal contamination occurs in the substrate due to an insufficient complex of carbon and oxygen. In addition, it is possible to prevent the density of gettering sinks from being lowered due to excessive agglutination of oxygen precipitates.

The inventors analyzed and examined the states and actions of carbon, oxygen, and boron. The examination results proved that, when a silicon single crystal was pulled under the conditions of a B concentration corresponding to a resistivity in the range of 8 mΩcm to 10 mΩcm, a carbon concentration in the range of 1.0 × 10¹⁶ atoms/cm³ to 1.6 × 10¹⁷ atoms/cm³, and an oxygen concentration in the range of 1.0 × 10¹⁸ atoms/cm³ to 10 × 10¹⁸ atoms/cm³, thereby obtaining a wafer, an epitaxial layer was formed on the wafer, and a heat treatment was performed at a temperature in the range of 600°C to 800°C, it was possible to form gettering sinks required to getter heavy metal as BMDs, and manufacture a silicon substrate having sufficient gettering capability.

Next, a model that is considered to show high gettering capability according to this embodiment of the present invention will be described.

A p- substrate having a dopant (B) concentration of about 1 × 10¹⁵ atoms/cm³ (0.5 × 10¹⁵ atoms/cm³ to 5 × 10¹⁵ atoms/cm³) and a resistivity of about 10 Ωcm is doped with carbon at a concentration of about 1 × 10¹⁷ atoms/cm³ (0.5 × 10¹⁵ atoms/cm³ to 1 × 10¹⁷ atoms/cm³) which is higher than the boron (B) concentration, and has an oxygen concentration in the range of 1.4 × 10¹⁸ atoms/cm³ to 1.6 × 10¹⁸ atoms/cm³. Then, since the carbon concentration and the oxygen concentration are higher than the boron (B) concentration, and the carbon concentration and the oxygen concentration are similar extent, it is considered that carbon and oxygen are likely to form a pair in the substrate during the post-annealing step S4. Therefore, it is considered that a pair of carbon and oxygen is formed as a bonding state related to a gettering sink in a silicon crystal.

The radius of a carbon atom is smaller than that of a silicon atom. Therefore, when carbon is put to the lattice point of silicon, the vicinity is distorted and a strain field are formed around the carbon. The post-annealing step S4 or the heat treatment in the device manufacturing step are performed on the substrate in this state. Then, interstitial oxygen is concentrated on the strain filed around the pair of carbon and oxygen, thereby forming a BMD. As such, C is doped into the silicon substrate in a device region or a position close to the surface of the wafer where heavy metal contamination is likely to occur, and the vicinity of the device region or the doped position is distorted. Therefore, heavy metal is diffused and gettered. As a result, a gettering effect is obtained. That is, the device region or the doped position becomes the nucleation center of an oxygen precipitate by the pair of carbon and oxygen.

It is expected that a vacancy in the silicon crystal and interstitial silicon (Si) will contribute to the formation of the complex.

In the present invention, these precipitate nuclei are referred to as complex defects caused by boron, carbon, and oxygen.

It is very important to prevent heavy metal contamination during the manufacture of a solid-state imaging device. Therefore, in addition to IG by B and O, texture is formed as EG on the rear surface of the substrate to obtain sufficient gettering capability.

Since the silicon substrate subjected to the post-annealing step S4 has good gettering characteristics, it is effective for a device that is sensitive to heavy metal contamination. In addition, in an electronic device manufacturing process, as the width of a wiring pattern is reduced, the influence of the flatness of a silicon substrate on device yield is increased. Therefore, high flatness is required. As in this embodiment of the present invention, a p+ substrate having high boron concentration that is doped with carbon can have sufficient gettering capability without forming PBS having low flatness.

Further, it is necessary to obtain a sufficient gettering effect until a device manufacturing process starts and maintain the gettering effect during the device step. Therefore, in a process of manufacturing a p type silicon substrate, when carbon is not doped, it is preferable to increase oxygen concentration to the range of about 10 × 10¹⁸ atoms/cm³ to 20 × 10¹⁸ atoms/cm³ for precipitation enhancement. However, when the concentration of oxygen in the substrate is increased, dislocation is likely to be extended to the epitaxial layer, which is called an epitaxial defect. In contrast, as in this embodiment of the present invention, when C is doped at the above-mentioned concentration and the post-annealing step S4 is performed, it is possible to prevent the occurrence of a stacking fault (SF) having a size of about 0.5 µm or more.

Furthermore, as in this embodiment of the present invention, when carbon is doped at the above-mentioned concentration, it is possible to prevent the extension of secondary defects from precipitate nuclei. The reason is as follows. In order to release strain generated from precipitates having a size of 0.5 µm to 5 µm, a secondary dislocation occurs around the strain field. However, when C is doped at the above-mentioned concentration, it is possible to form a plurality of precipitates having a size of 0.5 nm to 100 nm. In this case, even when the strain is released, a small secondary dislocation occurs, and the post-annealing step S4 prevents the dislocation from being extended to the epitaxial layer. In addition, since the density of a plurality of small precipitate nuclei is in the range of about 1.0 × 10¹⁰/cm³ to 1.0 × 10¹³/cm³, it is possible to obtain sufficient gettering capability.

Furthermore, in this embodiment of the present invention, when the concentration of carbon added to a silicon crystal is in the range of 1.0 × 10¹⁶ atoms/cm³ to 1.6 × 10¹⁷ atoms/cm³, gettering sinks having carbon, boron, or oxygen as nuclei are formed during a crystal growth process. Even when a high-temperature heat treatment is performed, these gettering sinks stably exist. Therefore, these gettering sinks exist even after epitaxial growth. Thus, oxygen precipitates act as precipitate nuclei immediately after epitaxial growth, are grown during a device heat treatment process, and serve as gettering sinks for heavy metal contamination during the device heat treatment process.

A manufacturing method according to this embodiment of the present invention may include the steps of: pulling a silicon single crystal having a boron (B) concentration corresponding to a resistivity in the range of 8 mΩcm to 10 mΩcm, a carbon concentration in the range of 1.0 × 10¹⁶ atoms/cm³ to 1.6 × 10¹⁷ atoms/cm³, and an oxygen concentration in the range of 1.4 × 10¹⁸ atoms/cm³ to 1.6 × 10¹⁸ atoms/cm³ using a CZ method; and slicing the pulled silicon single crystal into a silicon substrate and performing a heat treatment on the silicon substrate to form an oxygen precipitate.

In the manufacturing method according to this embodiment of the present invention, the heat treatment for forming the oxygen precipitate may be performed at a temperature in the range 600°C to 800°C for a process time of 0.25 hours to 3 hours in a mixed atmosphere of oxygen and an inert gas, such as argon or nitrogen.

Furthermore, the manufacturing method according to this embodiment of the present invention may further include a step of forming a silicon epitaxial layer having a B concentration corresponding to a resistivity of 0.1 Ωcm to 100 Ωcm on the surface of the sliced silicon substrate, before the heat treatment for forming the oxygen precipitate is performed.

Further, in this embodiment of the present invention, when the silicon single crystal is grown, hydrogen may be added to an inert gas atmosphere. In this case, in the silicon single crystal pulling step, the pressure of the inert gas atmosphere having hydrogen added thereto may be in the range of 1.33 kPa to 26.7 kPa, which is a reduced pressure range, and the concentration of hydrogen gas in the atmosphere may be in the range of 3 percent by volume to 20 percent by volume.

In addition, this embodiment of the present invention provides a silicon substrate manufactured by the above-mentioned manufacturing method. Among BMDs serving as intrinsic gettering sinks, the density of the BMDs having a size of 10 nm to 100 nm may be in the range of 1.0 × 10⁶ BMDs/cm³ to 1.0 × 10¹¹ BMDs/cm³.

In this case, the BMD size means the length of the diagonal line of a precipitate in the cross-sectional TEM image of the silicon substrate in the thickness direction, and indicates the average value of the precipitates in an observation field.

Further, the present invention provides a silicon substrate for a solid-state imaging device. The silicon substrate includes a gettering layer that is provided immediately below a buried photodiode of the solid-state imaging device and has a BMD density of 1.0 × 10⁰ BMDs/cm³ to 1.0 × 10¹¹ BMDs/cm³. In this case, the BMDs have a size of 10 nm to 100 nm. A silicon epitaxial layer having a boron (B) concentration corresponding to a resistivity in the range of 0.1 Ωcm to 100 Ωcm is formed immediately on the silicon substrate manufactured by the above-mentioned manufacturing method, and the gettering layer is provided immediately below the silicon epitaxial layer.

It is preferable that the silicon substrate be a p+ type. The reason is as follows. A p+ wafer (silicon substrate) can be used to prevent a so-called latch-up phenomenon in which a floating charge generated when a device is operated operates an unintended parasitic transistor in terms of the device design, and it is easy to design a device. In addition, when a capacitor having a trench structure is used, the p+ wafer can prevent a depletion layer from being extended when a voltage is applied around the trench.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A method of manufacturing a silicon substrate comprising:
growing a silicon single crystal having a carbon concentration in the range of 1.0 × 10¹⁶ atoms/cm³ to 1.6 × 10¹⁷ atoms/cm³ and an initial oxygen concentration in the range of 1.4 × 10¹⁸ atoms/cm³ to 1.6 × 10¹⁸ atoms/cm³ using a CZ method;
slicing the silicon single crystal;
forming an epitaxial layer on the sliced silicon single crystal; and
performing a heat treatment thereon as a post-annealing process at a temperature in the range of 600°C to 850°C.

2. A silicon substrate for a solid-state imaging device manufactured by the manufacturing method according to claim 1.

3. The method of manufacturing a silicon substrate according to claim 1, wherein in the step of growing the silicon single crystal, an internal pressure of a furnace is set in the range of 1.33 kPa to 26.7 kPa in an inert gas atmosphere and 3 to 20 percent by volume of hydrogen gas is mixed with an inert gas.

4. The method of manufacturing a silicon substrate according to claim 1, wherein in the step of growing the silicon single crystal, an internal pressure of a furnace is set in the range of 4 kPa to 26.7 kPa in an inert gas atmosphere and 3 to 20 percent by volume of hydrogen gas is mixed with an inert gas.

5. The method of manufacturing a silicon substrate according to claim 1, wherein in the step of growing the silicon single crystal, an internal pressure of a furnace is set in the range of 4 kPa to 9.3 kPa in an inert gas atmosphere and 3 to 20 percent by volume of hydrogen gas is mixed with an inert gas.

6. The method of manufacturing a silicon substrate according to claim 1, wherein in the step of performing the heat treatment, the heat treatment is performed for 0.25 hours to 4 hours at a mixed atmosphere of oxygen and an inert gas.

7. The method of manufacturing a silicon substrate according to claim 1, wherein oxygen precipitates in the sliced silicon single crystal after the heat treatment have a density in the range of 1.0 ×10⁶ BMDs/cm³ to 1.0 × 10¹¹ BMDs/cm³ and a size in the range of 10 nm to 100 nm.
